# EUROPEAN PATENT APPLICATION

(11) **EP 1 983 811 A2**
(43) Date of publication of application: **22.10.2008**
(21) Application number: 08153659.1
(22) Date of filing: 28.03.2008
(51) Int. Cl.: H05K 3/40, H01R 12/28

(54) **Electrical Contact**

(30) Priority: 18.04.2007 DE 102007018286; 03.10.2007 GB 0719266
(71) Applicant: Delphi Technologies, Inc., Troy, Michigan 48007 (US)
(72) Inventor: Andrzejewski, Jacek, 32-050, Skawina (PL); Hyrlicki, Marcin, 32-060, Liszki (PL); Toellner, Robert, 31162, Bad Salzdetfurth (DE); Floren, Christian, 31162, Hildesheim (DE)
(74) Representative: Denton, Michael John

(57) **Abstract**

An electrical contact (110) comprising a ring portion (112) defining an opening (114); a pair of spring arms (116) integral with the ring portion on diametrically opposed sides thereof, and directed inwardly towards one another; and a pair of solder pads (118) spaced from, and integral with, the ring portion on diametrically opposed sides thereof.

## Description

### Technical Field

The present invention relates to an electrical contact for a circuit board, and in particular to an electrical contact which can be soldered to electric conductors on the circuit board and which has a spring element for mechanical and electrical connection to a terminal pin.

### Background of the Invention

It is known to provide an electrical and mechanical connection between a terminal pin and an electrical conductor on a printed circuit board by passing the pin through an aperture in the board, and then soldering the pin to the conductor. DE 19735409 discloses a known alternative arrangement using an electrical contact. The contact is substantially annular with one or more inwardly directed spring arms. The outer ring portion is soldered to electrical conductors on a printed circuit board. The spring arms overlie an aperture in the circuit board. A terminal pin extends through the aperture, and makes a mechanical and electrical connection with the spring arms by way of a friction grip.

### Summary of the Invention

The aim of the present invention is to provide an improvement to the above-mentioned known arrangements.

An electrical contact in accordance with the present invention comprises a ring portion defining an opening; a pair of spring arms integral with the ring portion on diametrically opposed sides thereof, and directed inwardly towards one another; and a pair of solder pads spaced from, and integral with, the ring portion on diametrically opposed sides thereof.

By separating the solder area from the ring portion, the shape of the ring portion can be more readily adapted to provide improved resilience for the spring arms; improve stress distribution through the contact; and make the contact more susceptible for automated assembly of the contact to a printed circuit board.

In a preferred arrangement, the spring arms lie on a first diametrical axis, and the solder pads lie on a second diametrical axis, with the first and second axes being substantially perpendicular to one another. Alternatively, the first and second axes may be an angle other than ninety degrees. Further still, the first and second axes may be aligned.

Preferably, the spring arms are directed inwardly towards one another and at an angle to the plane of the ring portion. Alternatively, the spring arms may lie in substantially the same plane as the ring portion.

The ring portion preferably has a shape which is substantially that of the figure eight. In this case, the spring arms are preferably formed as the central portion of the eight-shape.

The solder pads are preferably located inside the opening. In this case, the solder pads are preferably substantially C-shaped and attached to the ring portion by a bridge portion. Alternatively, the solder pads may be located outside the ring portion.

Preferably, the solder pads lie in a plane which is spaced from the plane of the ring portion. Where the spring arms are directed away from the plane of the ring portion, the solder pads preferably lie in a plane on the opposite side of the ring portion to the spring arms.

### Brief Description of the Drawings

The present invention will now be described, by way of example, with reference to the accompanying drawings, in which:-
Figure 1 is a perspective view of a first embodiment of electrical contact in accordance with the present invention;
Figure 2 is a perspective view of a second embodiment of electrical contact in accordance with the present invention;
Figure 3A is a cross-sectional view, on axis A₁, of the contact of Figure 2 when soldered to a printed circuit board and attached to a terminal pin;
Figure 3B is a cross-sectional view, on axis A₂, of the contact of Figure 2 when soldered to a printed circuit board and attached to a terminal pin;
Figure 4 is a perspective view of the contact of Figure 2 when connected with a round terminal pin;
Figure 5 is a perspective view of the contact of Figure 2 when connected with a rectangular terminal pin;
Figures 6 and 7 illustrate the compensation tolerance of the arrangement shown in Figure 5; and
Figure 8 to 10 are top views of further embodiments of electrical contact in accordance with the present invention.

### Description of the Preferred Embodiment

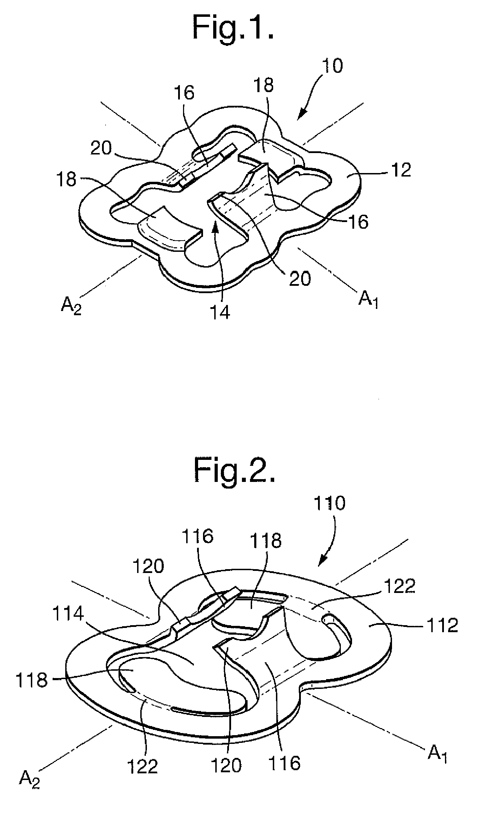

Referring to Figure 1 of the drawings, an electrical contact 10 in accordance with a first embodiment of the present invention includes a ring portion 12 defining an opening 14; a pair of spring arms 16 integral with the ring portion on diametrically opposed sides thereof, and directed inwardly towards one another; and a pair of solder pads 18 spaced from, and integral with, the ring portion on diametrically opposed sides thereof, and positioned within the opening. The spring arms 16 lie on a first diametrical axis A₁, and the solder pads 18 lie on a second diametrical axis A₂, with the first and second axes being substantially perpendicular to one another. In this embodiment, the ring portion 12 is substantially rectangular with curved corners, and with inwardly curved portions adjacent each spring arm 16 and each solder pad 18. In a preferred arrangement, as shown, the spring arms 16 are directed inwardly towards one another and at an angle to the plane of the ring portion 12. The separation of the free ends 20 of the spring arms 12 is a predetermined gap in order to provide a mechanical and electrical connection, by a friction fit, with a corresponding terminal pin (not shown), which may have a circular or rectangular cross-section.

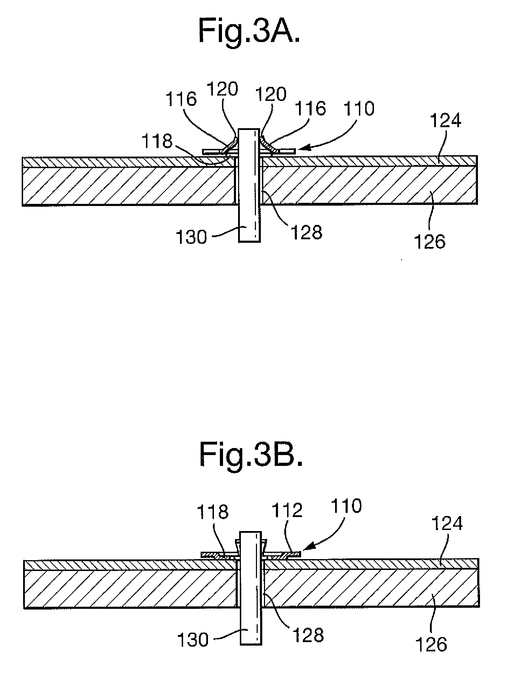

Referring to Figure 2 of the drawings, an electrical contact 110 in accordance with a second embodiment of the present invention includes a ring portion 112 defining an opening 114; a pair of spring arms 116 integral with the ring portion on diametrically opposed sides thereof, and directed inwardly towards one another; and a pair of solder pads 118 integral with, and spaced from, the ring portion on diametrically opposed sides thereof, and positioned within the opening. The spring arms 116 lie on a first diametrical axis A₁, and the solder pads 118 lie on a second diametrical axis A₂, with the first and second axes being substantially perpendicular to one another. In this embodiment, the ring portion 112 has a shaped which is substantially a figure of eight, with the spring arms 116 being formed from the central part of the eight-shape. In a preferred arrangement, as shown, the spring arms 116 are directed inwardly towards one another and at an angle to the plane of the ring portion 112. The separation of the free ends 120 of the spring arms 112 is a predetermined gap in order to provide a mechanical and electrical connection, by a friction fit, with a corresponding terminal pin (referred to below with respect to Figures 3 to 7), which may have a circular or rectangular cross-section. The solder pads 118 are substantially C-shaped and connected to the ring portion 112 by a bridge portion 122. The solder pads 118 preferably lie in a plane which is spaced from the plane of the ring portion 112 on the opposite side to the spring arms 116.

Figures 3A and B illustrates the use of the electrical contact 110 of Figure 2. In Figures 3A and B, the solder pads 118 of the contact 110 are soldered to electrical conductors 124 on a printed circuit board 126. The spring arms 116 are located over an aperture 128 in the printed circuit board 126. A terminal pin 130 extends through the aperture 128 and makes a mechanical and electrical connection, by a friction grip, with the free ends 120 of the spring arms 116 of the contact.

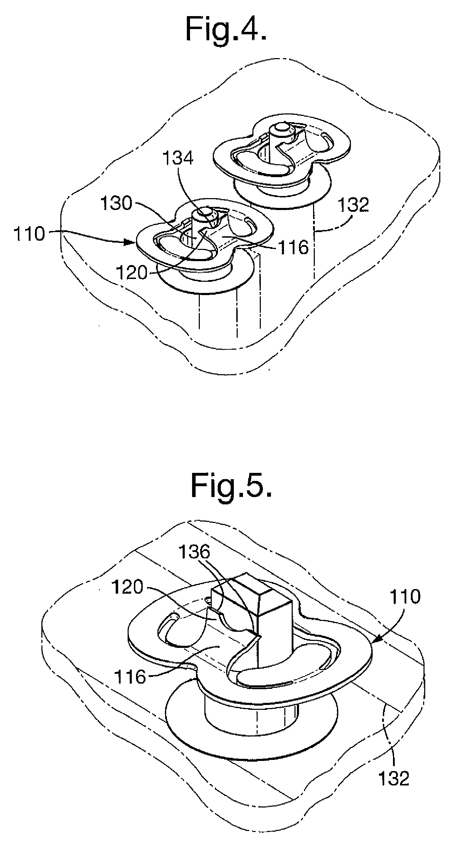

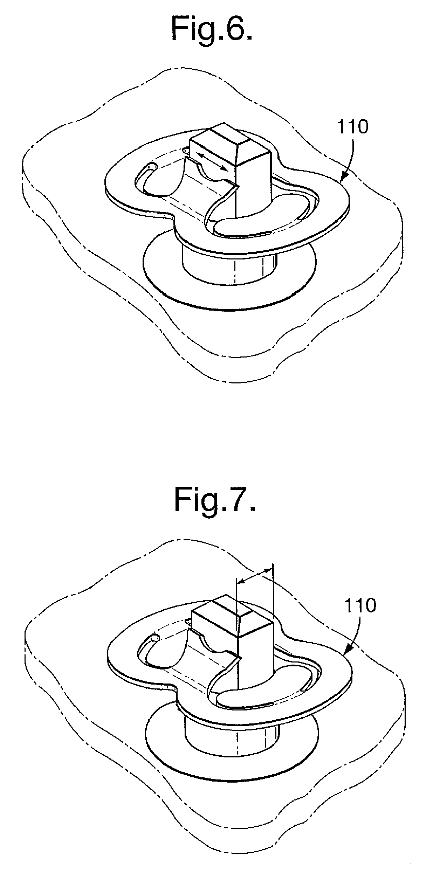

Figures 4 and 5 illustrate the use of the contact 110 of Figures 2 and 3 when the terminal pin 130 is integral with a grounding frame 132. The printed circuit board has been omitted to illustrate the arrangement. In Figure 4, the terminal pins 130 have a circular cross-section and engage with a curved portion 134 at the free end 120 of each spring arm 116. In Figure 5, the terminal pins 130 have a rectangular cross-section and engage with spaced linear portions 136 at the free end 120 of each spring arm 116. The connection between the terminal pins 130 and the contacts 110 is as illustrated in Figure 3. The terminal pins 130 and the grounding frame 132 are preferably integrally die-cast. Figures 6 and 7 illustrate tolerance compensation which is possible using the contacts of the present invention both in terms of pin dimensions and relative pin position.

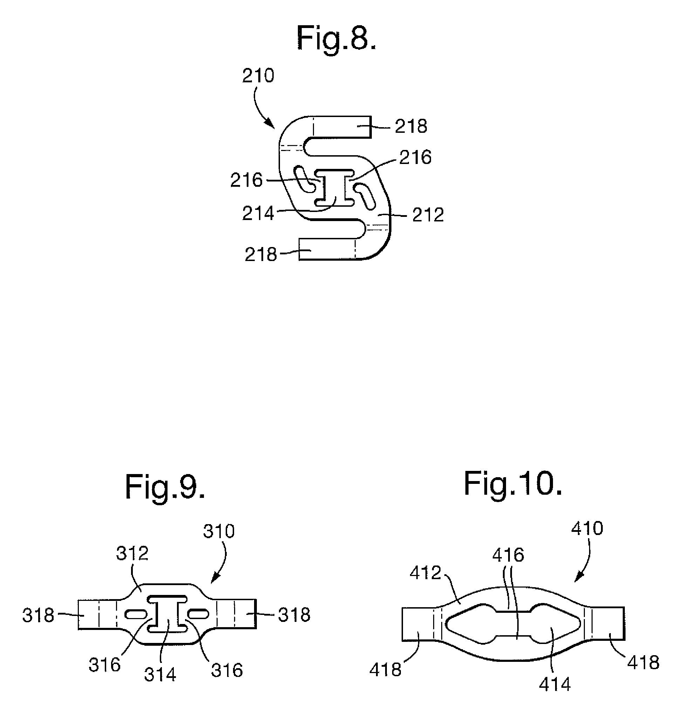

Referring to the further embodiments of electrical contact shown in Figures 8 to 10, in Figure 8 the electrical contact 210 is substantially S-shaped with the ring portion 212 and spring arms 216 defining the central portion of the S-shape and the solder pads 218 defining the outer portions of the S-shape and being positioned outwardly of the ring portion. In Figure 9, the electrical contact 310 is substantially elongated with the solder pads 318 being positioned outwardly of the ring portion 312 and axially aligned with the spring arms 316. In Figures 8 and 9, the ring portion 212, 312 defines an opening 214, 314 respectively which is substantially rectangular. In Figure 10, the ring portion 412 of the electrical contact 410 is substantially oval in shape and defines a substantially oval-shaped opening 414. In this embodiment, the solder pads 418 are positioned outwardly of the ring portion 412 along the longer axis of the oval, and the spring arms 416 lie on an axis substantially perpendicular to the axis of the solder pads. Other features of the electrical contacts of Figure 8 to 10 may be as described above with respect to the embodiments shown in Figures 1 and 2.

The present invention provides an electrical contact which is readily usable for automated assembly on a printed circuit board along with other circuit board components, thereby avoiding additional selective soldering process at a later stage. Once the contact is soldered then a terminal pin can be pushed into position. At the same time mechanical and electrical connection is provided. The present invention has particular application with terminal pins which are die cast integrally with a grounding frame, in which case such terminal pins cannot be readily soldered to electrical contacts. The present invention can be applied to different types of printed circuit board and different shapes and types of terminal pin.

The electrical contact of the present invention has a number of interrelated features. The option of positioning of the solder pads surfaces at lower level with the respect to the ring portion (illustrated in Figure 2) assists the automated assembly process. Further, in this respect, mechanical deformation of the contact is possible without interference which allows the ring portion to be spaced from the printed circuit board. The shape of the ring portion can provide substantially even distribution of stress and also allows operating in an elastic range once placed on a printed circuit board and mounted together with the terminal pins.

The spring arms are pre-shaped prior to mounting of the contact on a printed circuit board and further assembly steps. During connection to a terminal pin, the spring arms resiliently deform and make contact with (friction grip) the terminal pin. The elasticity range and friction force can be determined to protect the printed circuit board against disconnection from the terminal pin during normal use. The shape of the free ends of the spring arms can be set to assure the required mechanical and electrical contact between printed circuit board and the terminal pin. The angle of pitch of the spring arms can be optimized to obtain a small assembly force and a high disassembly force.

## Claims

1. An electrical contact comprising a ring portion defining an opening; and a pair of spring arms integral with the ring portion on diametrically opposed sides thereof, and directed inwardly towards one another; **characterised by** a pair of solder pads spaced from, and integral with, the ring portion on diametrically opposed sides thereof.

2. An electrical contact as claimed in Claim 1, wherein the solder pads are located inside the opening.

3. An electrical contact as claimed in Claim 2, wherein the solder pads are substantially C-shaped and attached to the ring portion by a bridge portion.

4. An electrical contact as claimed in Claim 1, wherein the solder pads are located outside the ring portion.

5. An electrical contact as claimed in any one of the preceding claims, wherein the spring arms lie on a first diametrical axis, and the solder pads lie on a second diametrical axis, with the first and second axes being substantially perpendicular to one another.

6. An electrical contact as claimed in any one of Claims 1 to 4, wherein the spring arms lie on a first diametrical axis, and the solder pads lie on a second diametrical axis, with the first and second axes at an angle other than ninety degrees.

7. An electrical contact as claimed in any one of Claims 1 to 4, wherein the spring arms lie on a first diametrical axis, and the solder pads lie on a second diametrical axis, with the first and second axes being aligned.

8. An electrical contact as claimed in any one of the preceding claims, wherein the spring arms are directed inwardly towards one another and at an angle to the plane of the ring portion.

9. An electrical contact as claimed in any one of Claims 1 to 7, wherein the spring arms lie in substantially the same plane as the ring portion.

10. An electrical contact as claimed in any one of the preceding claims, wherein the ring portion has a shape which is substantially that of the figure eight.

11. An electrical contact as claimed in Claim 10, wherein the spring arms are formed as the central portion of the eight-shape.

12. An electrical contact as claimed in any one of the preceding claims, wherein the solder pads lie in a plane which is spaced from the plane of the ring portion.

13. An electrical contact as claimed in Claim 12, in which the spring arms are directed away from the plane of the ring portion, wherein the solder pads lie in a plane on the opposite side of the ring portion to the spring arms.

14. An electrical contact as claimed in any one of the preceding claims, wherein the contact is substantially S-shaped with the ring portion and spring arms defining the central portion of the S-shape and the solder pads defining the outer portions of the S-shape.
